# EUROPEAN PATENT APPLICATION

(11) **EP 4 506 992 A1**
(43) Date of publication of application: **12.02.2025**
(21) Application number: 22936251.2
(22) Date of filing: 24.04.2022
(51) Int. Cl.: H01L 25/075, H01L 33/48, H01L 33/62, G09G 3/32

(54) **FULL-COLOR LAMP BEAD, DRIVE CIRCUIT, LAMP PANEL AND DISPLAY MODULE FOR LED DISPLAY SCREEN**

(30) Priority: 06.04.2022 CN 202220785364 U
(71) Applicant: Xiamen Qiangli Jucai Opto-Electronic Technology Co., Ltd, Xiamen, Fujian 361000 (CN)
(72) Inventor: ZHU, Zhiqiang, Xiamen, Fujian 361000 (CN); ZHOU, Guohua, Xiamen, Fujian 361000 (CN); ZHOU, Zongji, Xiamen, Fujian 361000 (CN); LIN, Xunjie, Xiamen, Fujian 361000 (CN)
(74) Representative: Cabinet Chaillot
(86) International application number: PCT/CN2022/088709
(87) International publication number: WO 2023/193315

(57) **Abstract**

Disclosed in the present invention are a full-color lamp bead, drive circuit, lamp panel and display module for an LED display screen. A full-color lamp bead unit of the full-color lamp bead comprises a red-light LED chip, a green-light LED chip, a blue-light LED chip, and a common positive pad, a red-light chip negative pad, a green-light chip negative pad and a blue-light chip negative pad, which are formed on a substrate, wherein a negative electrode of the red-light LED chip is connected to the red-light chip negative pad, and a positive electrode of the red-light LED chip is connected to the common positive pad; the green-light LED chip and the blue-light LED chip are fixed on the common positive pad; positive electrodes of the green-light LED chip and the blue-light LED chip are connected to the common positive pad; and negative electrodes of the green-light LED chip and the blue-light LED chip are respectively connected to the green-light chip negative pad and the blue-light chip negative pad. By means of the full-color lamp bead of the present invention, the phenomenon of a short circuit between negative electrodes does not occur, such that the "caterpillar phenomenon" can be prevented from occurring in an LED display screen.

## Description

### TECHNICAL FIELD

The present invention relates to the field of LED display screens, and in particular, to a full-color lamp bead, a drive circuit, a lamp panel, and a display module of an LED display screen.

### BACKGROUND OF THE INVENTION

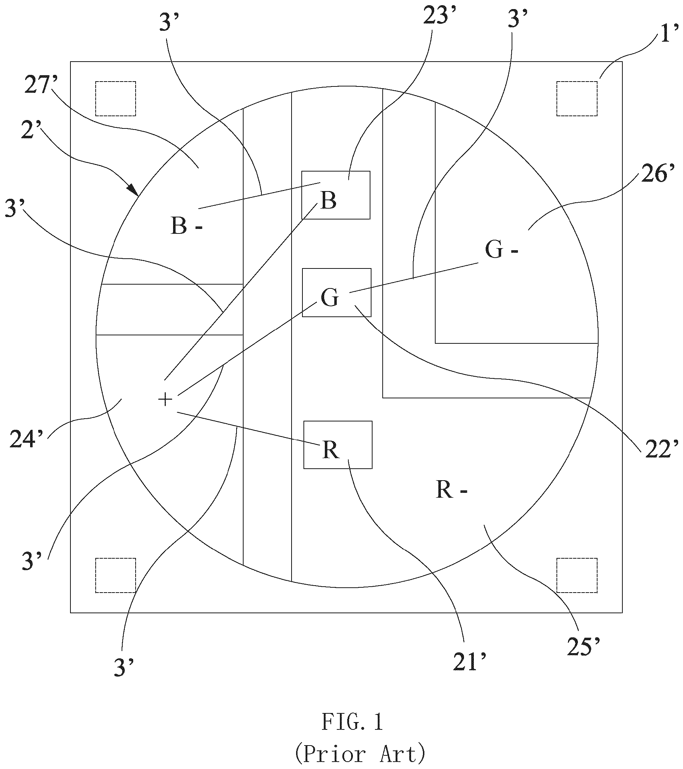

With reference to FIG. 1, in a full-color lamp bead used in an existing LED display screen, a red-light LED chip 21', a green-light LED chip 22', and a blue-light LED chip 23' of a full-color lamp bead unit 2' of the full-color lamp bead are disposed on a substrate 1' in a common anode (positive pole) connection mode. Specifically, positive and negative electrodes of the red-light LED chip 21' are located on a front side and a back side of the red-light LED chip 21' respectively; positive and negative electrodes of the green-light LED chip 22' are disposed on a front side of the green-light LED chip 22'; positive and negative electrodes of the blue-light LED chip 23' are disposed on a front side of the blue-light LED chip 23'. In the full-color lamp bead unit 2', the negative electrode of the red-light LED chip 21' as well as a back side of the green-light LED chip 22' and a back side of the blue-light LED chip 23' are fixed to a red-light chip negative pad 25'; the negative electrode of the green-light LED chip 22' is connected to a green-light chip negative pad 26' through a metal wire 3'; the negative electrode of the blue-light LED chip 23' is connected to a blue-light chip negative pad 27' through a metal wire 3'; the positive electrode of the red-light LED chip 21', the positive electrode of the green-light LED chip 22', and the positive electrode of the blue-light LED chip 23' are connected to a common positive pad 24' through respective metal wires 3'; the common positive pad 24', the red-light chip negative pad 25', the green-light chip negative pad 26', and the blue-light chip negative pad 27' are all formed on the substrate 1'.

When such existing full-color lamp bead is applied to an LED display screen and being scan driven, the following problem tends to occur: specifically, the green-light LED chip 22' or the blue-light LED chip 23' of the full-color lamp bead unit 2' of the full-color lamp bead may experience technical failures such as chip burn, metal migration or adhesion with a pin, resulting in the negative electrode of the green-light LED chip 22' or the blue-light LED chip 23' being electrically conducted with the red-light chip negative pad 25', and thus the red-light chip negative pad 25' is electrically conducted with the green-light chip negative pad 26', and/or the red-light chip negative pad 25' is electrically conducted with the blue-light chip negative pad 27', in other words, the problem of short circuit between negative electrodes occurs in the full-color lamp bead unit 2' of the full-color lamp bead. In this case, since an on voltage of the red-light LED chip 21' is lower than on voltages of the green-light LED chip 22' and the blue-light LED chip 23', the damaged full-color lamp bead unit 2' can only display red light. Also, since a plurality of full-color lamp bead units 2' in each column of the LED display screen are connected in parallel, if one of the full-color lamp bead units 2' in the column is damaged with the problem of short circuit between negative electrodes, the entire column of full-color lamp bead units 2' in which the damaged full-color lamp bead units 2' is located will then only be able to display red color. This phenomenon is commonly referred to as the "caterpillar phenomenon" in the art (that is, the crosstalk phenomenon in the LED display) that significantly affects the display effect of an LED display screen.

When the "caterpillar phenomenon" occurs on the LED display screen, a control system of the LED display screen cannot regulate the voltage through a column driver chip to solve the problem. In addition, during maintenance, the full-color lamp beads in the entire column where the "caterpillar phenomenon" occurs need to be checked one by one to screen out the damaged full-color lamp bead, which leads to low maintenance efficiency. Furthermore, the disassembly and reinstallation of the full-color lamp bead have a certain impact on the service life of the full-color lamp bead, thus resulting in a poor maintenance result. Therefore, the "caterpillar phenomenon" occurring in the LED display screen is a difficult and bothering technical challenge in the art that urgently needs to be solved.

### BRIEF SUMMARY OF THE INVENTION

In view of the aforesaid disadvantages in the prior art, the present invention provides a full-color lamp bead, a drive circuit, a lamp panel, and a display module of an LED display screen.

To attain the above object, the present invention provides the following technical solutions: A full-color lamp bead for an LED display screen, comprising a substrate and at least one full-color lamp bead unit; each full-color lamp bead unit comprises a red-light LED chip, a green-light LED chip, and a blue-light LED chip, and further comprises a common positive pad, a red-light chip negative pad, a green-light chip negative pad, and a blue-light chip negative pad formed on the substrate; wherein a positive electrode and a negative electrode of the red-light LED chip are located on a front side and a back side of the red-light LED chip respectively; the negative electrode of the red-light LED chip is conductively connected to the red-light chip negative pad, and the positive electrode of the red-light LED chip is connected to the common positive pad through a metal wire; a positive electrode and a negative electrode of the green-light LED chip are both located on a front side of the green-light LED chip; a back side of the green-light LED chip is fixed on the common positive pad; the positive electrode of the green-light LED chip is connected to the common positive pad through a metal wire, and the negative electrode of the green-light LED chip is connected to the green-light chip negative pad through a metal wire; a positive electrode and a negative electrode of the blue-light LED chip are both located on a front side of the blue-light LED chip; a back side of the blue-light LED chip is fixed on the common positive pad; the positive electrode of the blue-light LED chip is connected to the common positive pad through a metal wire, and the negative electrode of the blue-light LED chip is connected to the blue-light chip negative pad through a metal wire.

The common positive pad and the red-light chip negative pad of each full-color lamp bead unit are located on one side of the full-color lamp bead unit; the green-light chip negative pad and the blue-light chip negative pad of each full-color lamp bead unit are located on another side of the full-color lamp bead unit.

The negative electrode of the red-light LED chip of each full-color lamp bead unit is soldered or bonded with conductive adhesive to the red-light chip negative pad.

The common positive pad, the red-light chip negative pad, the green-light chip negative pad, and the blue-light chip negative pad of each full-color lamp bead unit are separated by insulating baffles.

Said at least one full-color lamp bead unit comprises two full-color lamp bead units arranged side by side.

Said at least one full-color lamp bead unit comprises four full-color lamp bead units arranged in an array.

A drive circuit of an LED display screen; the drive circuit comprises row drive units, a red-light column drive unit, a green-light column drive unit, a blue-light column drive unit, and a plurality of full-color lamp beads described above; the full-color lamp bead units of the full-color lamp beads are arranged in an array; common positive pads of the full-color lamp bead units of each row of the plurality of full-color lamp beads are jointly connected to a respective row drive unit; red-light chip negative pads of the full-color lamp bead units of each column of the plurality of full-color lamp beads are jointly connected to same said red-light column drive unit; green-light chip negative pads of the full-color lamp bead units of each column of the plurality of full-color lamp beads are jointly connected to same said green-light column drive unit; blue-light chip negative pads of the full-color lamp bead units of each column of the plurality of full-color lamp beads are jointly connected to same said blue-light column drive unit.

A lamp panel of an LED display screen; the lamp panel comprises a PCB board and the drive circuit described above; the row drive units, the red-light column drive unit, the green-light column drive unit, the blue-light column drive unit, and the full-color lamp beads of the drive circuit are disposed on the PCB board; the full-color lamp beads of the drive circuit are arranged in an array on a same side of the PCB board.

A display module of an LED display screen; the display module comprises a bottom case and the lamp panel described above; the lamp panel is installed on the bottom case.

### Beneficial effects of the present invention:

According to the above technical solutions, since the green-light LED chip and the blue-light LED chip of each full-color lamp bead unit of the full-color lamp bead are disposed on the common positive pad, the green-light LED chip and the blue-light LED chip are not connected to the red-light chip negative pad of the full-color lamp bead unit. Therefore, when technical failures occur in the green-light LED chip or the blue-light LED chip of the full-color lamp bead unit 2, the failed green-light LED chip or blue-light LED chip forms a short circuit with the common positive pad, that is, a phenomenon of positive electrode-negative electrode short circuit occurs. In this case, the red-light chip negative pad of the full-color lamp bead unit is not electrically conducted with the green-light chip negative pad, or the red-light chip negative pad is not electrically conducted with the blue-light chip negative pad, in other words, the phenomenon of short circuit between negative electrodes can be avoided in each full-color lamp bead unit of the full-color lamp bead according to the present invention. Therefore, when a plurality of full-color lamp beads according to the present invention are applied to an LED display screen which is scan driven, if technical failures occur in the green-light LED chip or the blue-light LED chip of any full-color lamp bead unit of any one of the full-color lamp beads, the phenomenon of positive electrode-negative electrode short circuit instead of the phenomenon of short circuit between negative electrodes occurs in the damaged full-color lamp bead unit. In this case, a control system of the LED display screen can regulate the voltages of other full-color lamp bead units of other full-color lamp beads in a same column where the damaged full-color lamp bead unit is located by using respective row drive units, so as to control the display of other full-color lamp beads in the same column where the damaged full-color lamp bead unit is located and avoid the occurrence of the "caterpillar phenomenon" in that column of full-color lamp beads where the damaged full-color lamp bead unit is located. As a result, the impact on the display effect of the LED display screen is reduced, and the product quality of the LED display screen is improved. Further, when repairing the LED display screen, the damaged full-color lamp bead unit will not light up due to the phenomenon of positive electrode-negative electrode short circuit, and so the maintenance workers can quickly locate the full-color lamp bead containing the damaged full-color lamp bead units for replacement, thereby improving maintenance efficiency.

### BRIEF DESCRIPTION OF THE DRAWINGS

FIG. 1 is a schematic diagram of an existing full-color lamp bead.
FIG. 2 is a schematic diagram of a first embodiment of a full-color lamp bead according to the present invention.
FIG. 3 is a schematic diagram of a second embodiment of a full-color lamp bead according to the present invention.
FIG. 4 is a schematic diagram of a third embodiment of a full-color lamp bead according to the present invention.
FIG. 5 is a schematic circuit diagram of a drive circuit according to the present invention (using the full-color lamp bead of the first embodiment).
FIG. 6 is a schematic structural diagram of a lamp panel according to the present invention.
FIG. 7 is a schematic structural diagram of a display module according to the present invention.

### Reference numerals in the figures:

Background art in FIG. 1: substrate 1', full-color lamp bead unit 2', red-light LED chip 21', green-light LED chip 22', blue-light LED chip 23', metal wire 3', common positive pad 24', red-light chip negative pad 25', green-light chip negative pad 26', and blue-light chip negative pad 27'.

Detailed description of the present invention: display module a, bottom case b, lamp panel c, PCB board d, drive circuit e, full-color lamp bead A, substrate 1, full-color lamp bead unit 2, red-light LED chip 21, green-light LED chip 22, blue-light LED chip 23, common positive pad 24, red-light chip negative pad 25, green-light chip negative pad 26, blue-light chip negative pad 27, metal wire 3, row drive unit H, red-light column drive unit R, green-light column drive unit G, and blue-light column drive unit B.

### DETAILED DESCRIPTION OF THE INVENTION

To further explain the technical solutions of the present invention, a detailed description of the present invention is provided hereinafter through specific embodiments.

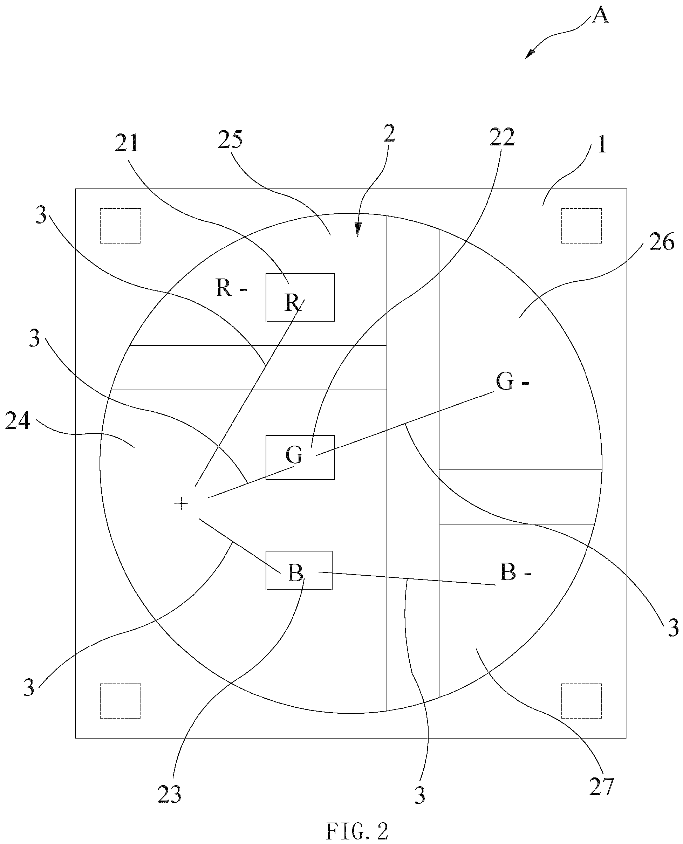

As shown in FIGs. 2 to 4, the present invention discloses a full-color lamp bead A, comprising a substrate 1 and at least one full-color lamp bead unit 2; the full-color lamp bead unit 2 comprises a red-light LED chip 21, a green-light LED chip 22, and a blue-light LED chip 23, and further comprises a common positive pad 24, a red-light chip negative pad 25, a green-light chip negative pad 26, and a blue-light chip negative pad 27 formed on the substrate 1.

With reference to FIGs. 2 to 4, in each full-color lamp bead unit 2, a positive electrode and a negative electrode of the red-light LED chip 21 are located on a front side and a back side of the red-light LED chip 21 respectively; the negative electrode of the red-light LED chip 21 is conductively connected to the red-light chip negative pad 25, and the positive electrode of the red-light LED chip 21 is connected to the common positive pad 24 through a metal wire 3; a positive electrode and a negative electrode of the green-light LED chip 22 are both located on a front side of the green-light LED chip 22; a back side of the green-light LED chip 22 is fixed on the common positive pad 24; the positive electrode of the green-light LED chip 22 is connected to the common positive pad 24 through a metal wire 3, and the negative electrode of the green-light LED chip 22 is connected to the green-light chip negative pad 26 through a metal wire 3; a positive electrode and a negative electrode of the blue-light LED chip 23 are both located on a front side of the blue-light LED chip 23; a back side of the blue-light LED chip 23 is fixed on the common positive pad 24; the positive electrode of the blue-light LED chip 23 is connected to the common positive pad 24 through a metal wire 3, and the negative electrode of the blue-light LED chip 23 is connected to the blue-light chip negative pad 27 through a metal wire 3.

In the present invention, since the green-light LED chip 22 and the blue-light LED chip 23 of each full-color lamp bead unit 2 of the full-color lamp bead A are disposed on the common positive pad 24, the green-light LED chip 22 and the blue-light LED chip 23 are not connected to the red-light chip negative pad 25 of the full-color lamp bead unit 2. Therefore, when technical failures (such as chip burn and metal migration) occur in the green-light LED chip 22 or the blue-light LED chip 23 of the full-color lamp bead unit 2, the failed green-light LED chip 22 or blue-light LED chip 23 forms a short circuit with the common positive pad 24, that is, a phenomenon of positive electrode-negative electrode short circuit occurs. In this case, the red-light chip negative pad 25 of the full-color lamp bead unit 2 is not electrically conducted with the green-light chip negative pad 26, or the red-light chip negative pad 25 is not electrically conducted with the blue-light chip negative pad 27, in other words, the phenomenon of short circuit between negative electrodes can be avoided in each full-color lamp bead unit 2 of the full-color lamp bead A according to the present invention. Therefore, when a plurality of full-color lamp beads A according to the present invention are applied to an LED display screen which is scan driven, if technical failures occur in the green-light LED chip 22 or the blue-light LED chip 23 of any full-color lamp bead unit 2 of any one of the full-color lamp beads A, the phenomenon of positive electrode-negative electrode short circuit instead of the phenomenon of short circuit between negative electrodes occurs in the damaged full-color lamp bead unit 2. In this case, a control system of the LED display screen can regulate the voltages of other full-color lamp bead units 2 of other full-color lamp beads A in a same column where the damaged full-color lamp bead unit 2 is located by using respective row drive units H, so as to control the display of other full-color lamp beads A in the same column where the damaged full-color lamp bead unit 2 is located and avoid the occurrence of the "caterpillar phenomenon" in that column of full-color lamp beads A where the damaged full-color lamp bead unit 2 is located. As a result, the impact on the display effect of the LED display screen is reduced, and the product quality of the LED display screen is improved. Further, when repairing the LED display screen, the damaged full-color lamp bead unit 2 will not light up due to the phenomenon of positive electrode-negative electrode short circuit, and so the maintenance workers can quickly locate the full-color lamp bead A containing the damaged full-color lamp bead units 2 for replacement, thereby improving maintenance efficiency.

With reference to FIG. 2, in the present invention, the common positive pad 24 and the red-light chip negative pad 25 of each full-color lamp bead unit 2 are located on one side of the full-color lamp bead unit 2; the green-light chip negative pad 26 and the blue-light chip negative pad 27 of each full-color lamp bead unit 2 are located on another side of the full-color lamp bead unit 2; such arrangements facilitate the red-light LED chip 21, the green-light LED chip 22, and the blue-light LED chip 23 of each full-color lamp bead unit 2 to be arranged in a row/column, and enabling the full-color lamp bead A of the present invention to be adaptable to an original circuit board of the LED display screen. The negative electrode of the red-light LED chip 21 of the full-color lamp bead unit 2 may be soldered or bonded with conductive adhesive to the red-light chip negative pad 25. The common positive pad 24, the red-light chip negative pad 25, the green-light chip negative pad 26, and the blue-light chip negative pad 27 of the full-color lamp bead unit 2 may be separated by insulating baffles, so as to prevent the common positive pad 24, the red-light chip negative pad 25, the green-light chip negative pad 26, and the blue-light chip negative pad 27 from being electrically conducted due to overflow of the conductive adhesive.

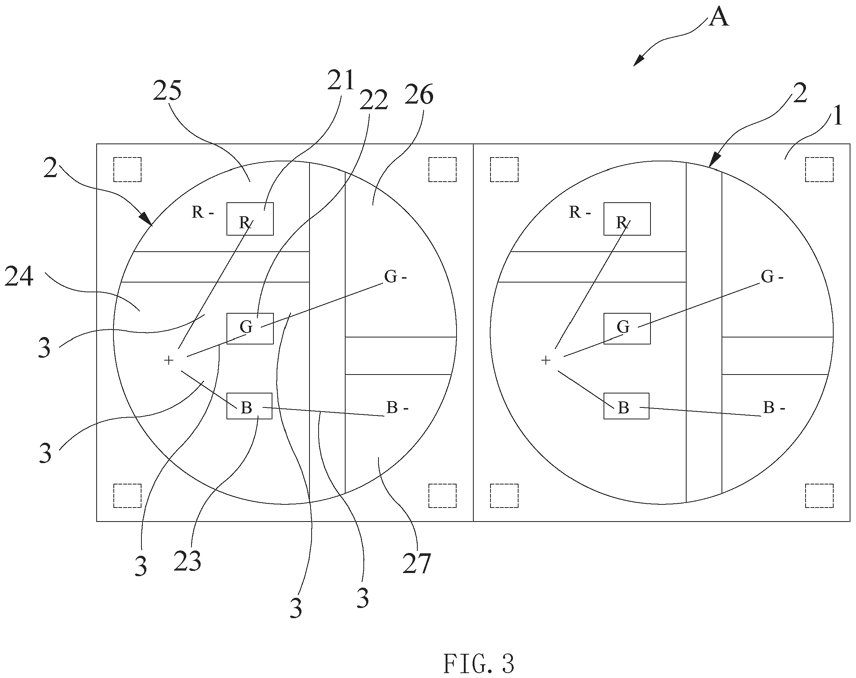

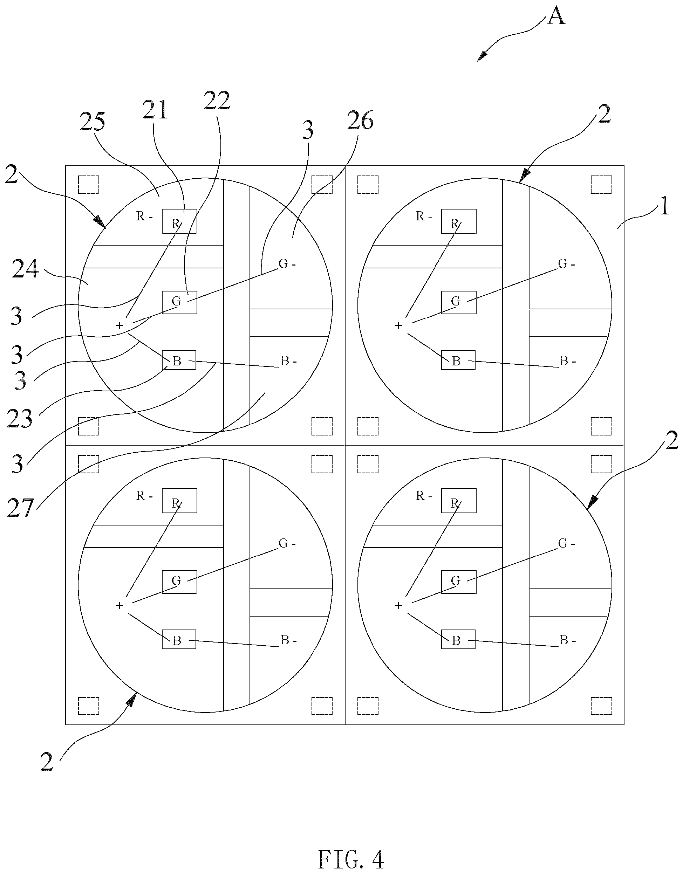

With reference to FIG. 2, in a first embodiment of the full-color lamp bead A of the present invention, a number of the full-color lamp bead unit 2 of the full-color lamp bead A is one, that is, the full-color lamp bead A is a lamp bead with a single full-color lamp bead unit; with reference to FIG. 3, in a second embodiment of the full-color lamp bead A of the present invention, two full-color lamp bead units 2 are provided on the full-color lamp bead A, and the two full-color lamp bead units 2 are arranged side by side, in other words, the full-color lamp bead A is a lamp bead with two full-color lamp bead units integrated thereon; with reference to FIG. 4, in a third embodiment of the full-color lamp bead A of the present invention, there are four full-color lamp bead units 2 provided of the full-color lamp bead A, and the four full-color lamp bead units 2 are arranged in an array, in other words, the full-color lamp bead A is a lamp bead with four full-color lamp bead units integrated thereon.

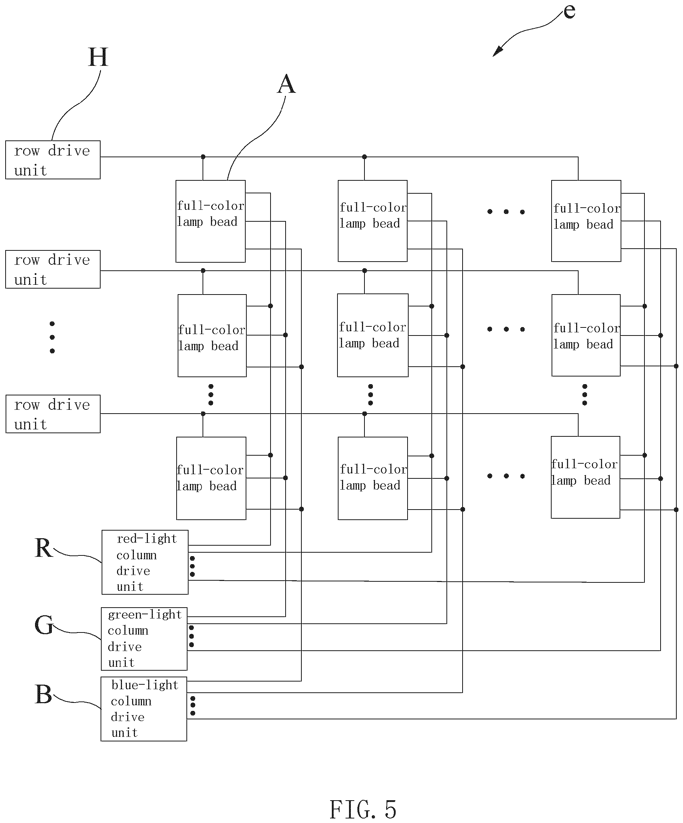

With reference to FIG. 5, the present invention further discloses a drive circuit e of an LED display screen; the drive circuit e comprises row drive units H, a red-light column drive unit R, a green-light column drive unit G, a blue-light column drive unit B, and a plurality of full-color lamp beads A described above according to the first embodiment; the full-color lamp bead units 2, and thus the full-color lamp beads A, are arranged in an array; common positive pads 24 of the full-color lamp bead units 2 of each row of the plurality of full-color lamp beads A are jointly connected to a respective row drive unit H; red-light chip negative pads 25 of the full-color lamp bead units 2 of each column of the plurality of full-color lamp beads A are jointly connected to same said red-light column drive unit R; green-light chip negative pads 26 of the full-color lamp bead units 2 of each column of the plurality of full-color lamp beads A are jointly connected to same said green-light column drive unit G; blue-light chip negative pads 27 of the full-color lamp bead units 2 of each column of the plurality of full-color lamp beads A are jointly connected to same said blue-light column drive unit B. The full-color lamp beads A described above are used by the drive circuit e to avoid the occurrence of the "caterpillar phenomenon".

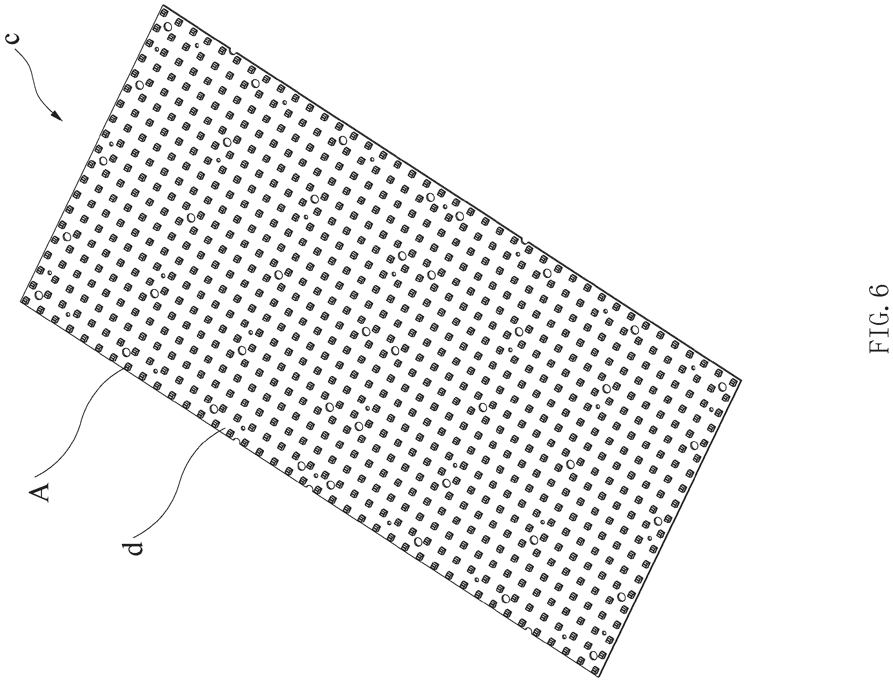

With reference to FIG. 6, the present invention further discloses a lamp panel c of an LED display screen; the lamp panel c comprises a PCB board d and the drive circuit e described above. The row drive units H, the red-light column drive unit R, the green-light column drive unit G, the blue-light column drive unit B, and the full-color lamp beads A of the drive circuit e are disposed on the PCB board d; the full-color lamp beads A of the drive circuit e are arranged in an array on a same side of the PCB board d. Specifically, the full-color lamp beads A of the drive circuit e are arranged in an array on a front side of the PCB board d, and the row drive units H, the red-light column drive unit R, the green-light column drive unit G, and the blue-light column drive unit B of the drive circuit e are disposed on a back side of the PCB board d. The drive circuit e described above is used by the lamp panel c to avoid the occurrence of the "caterpillar phenomenon".

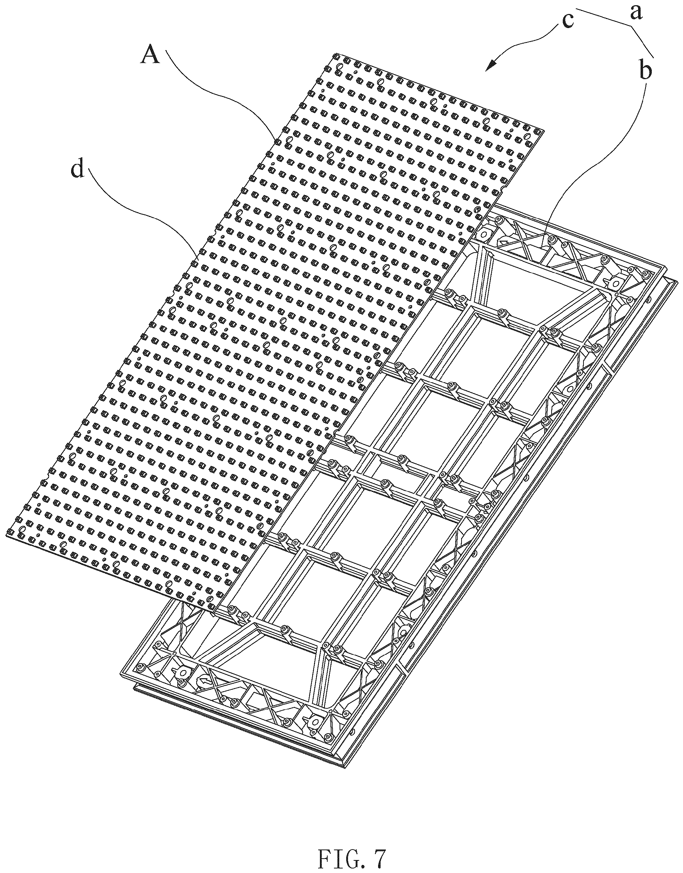

With reference to FIG. 7, the present invention further discloses a display module a of an LED display screen; the display module a comprises a bottom case b and the lamp panel c described above; the lamp panel c is installed on the bottom case b; the lamp plate c described above is used by the display module a to avoid the occurrence of the "caterpillar phenomenon".

The above embodiments and illustrations are not intended to limit the form and style of the product of the present invention. Any appropriate variations or modifications made by those of ordinary skills in the art shall be considered as falling within the scope of the patent of the present invention.

## Claims

1. A full-color lamp bead (A) for an LED display screen, comprising a substrate (1) and at least one full-color lamp bead unit (2);
each full-color lamp bead unit (2) comprises a red-light LED chip (21), a green-light LED chip (22), and a blue-light LED chip (23), and further comprises a common positive pad (24), a red-light chip negative pad (25), a green-light chip negative pad (26), and a blue-light chip negative pad (27) formed on the substrate (1); **characterized in that**: a positive electrode and a negative electrode of the red-light LED chip (21) are located on a front side and a back side of the red-light LED chip (21) respectively; the negative electrode of the red-light LED chip (21) is conductively connected to the red-light chip negative pad (25), and the positive electrode of the red-light LED chip (21) is connected to the common positive pad (24) through a metal wire (3); a positive electrode and a negative electrode of the green-light LED chip (22) are both located on a front side of the green-light LED chip (22); a back side of the green-light LED chip (22) is fixed on the common positive pad (24); the positive electrode of the green-light LED chip (22) is connected to the common positive pad (24) through a metal wire (3), and the negative electrode of the green-light LED chip (22) is connected to the green-light chip negative pad (26) through a metal wire (3); a positive electrode and a negative electrode of the blue-light LED chip (23) are both located on a front side of the blue-light LED chip (23); a back side of the blue-light LED chip (23) is fixed on the common positive pad (24); the positive electrode of the blue-light LED chip (23) is connected to the common positive pad (24) through a metal wire (3), and the negative electrode of the blue-light LED chip (23) is connected to the blue-light chip negative pad (27) through a metal wire (3).

2. The full-color lamp bead (A) of claim 1, wherein the common positive pad (24) and the red-light chip negative pad (25) of each full-color lamp bead unit (2) are located on one side of the full-color lamp bead unit (2); the green-light chip negative pad (26) and the blue-light chip negative pad (27) of each full-color lamp bead unit (2) are located on another side of the full-color lamp bead unit (2).

3. The full-color lamp bead (A) of claim 1, wherein the negative electrode of the red-light LED chip (21) of each full-color lamp bead unit (2) is soldered or bonded with conductive adhesive to the red-light chip negative pad (25).

4. The full-color lamp bead (A) of claim 1, wherein the common positive pad (24), the red-light chip negative pad (25), the green-light chip negative pad (26), and the blue-light chip negative pad (27) of each full-color lamp bead unit (2) are separated by insulating baffles.

5. The full-color lamp bead (A) of claim 1, wherein said at least one full-color lamp bead unit (2) comprises two full-color lamp bead units (2) arranged side by side.

6. The full-color lamp bead (A) of claim 1, wherein said at least one full-color lamp bead unit (2) comprises four full-color lamp bead units (2) arranged in an array.

7. A drive circuit (e) of an LED display screen; the drive circuit (e) comprises row drive units (H), a red-light column drive unit (R), a green-light column drive unit (G), a blue-light column drive unit (B), and a plurality of full-color lamp beads (A) each being the full-color lamp bead (A) of any one claims 1 to 6;
the full-color lamp bead units (2) of the full-color lamp beads (A) are arranged in an array; common positive pads (24) of the full-color lamp bead units (2) of each row of the plurality of full-color lamp beads (A) are jointly connected to a respective row drive unit (H); red-light chip negative pads (25) of the full-color lamp bead units (2) of each column of the plurality of full-color lamp beads (A) are jointly connected to same said red-light column drive unit (R); green-light chip negative pads (26) of the full-color lamp bead units (2) of each column of the plurality of full-color lamp beads (A) are jointly connected to same said green-light column drive unit (G); blue-light chip negative pads (27) of the full-color lamp bead units (2) of each column of the plurality of full-color lamp beads (A) are jointly connected to same said blue-light column drive unit (B).

8. A lamp panel (c) of an LED display screen; the lamp panel (c) comprises a PCB board (d) and the drive circuit (e) of claim 7; the row drive units (H), the red-light column drive unit (R), the green-light column drive unit (G), the blue-light column drive unit (B), and the full-color lamp beads (A) of the drive circuit (e) are disposed on the PCB board (d); the full-color lamp beads (A) of the drive circuit (e) are arranged in an array on a same side of the PCB board (d).

9. A display module (a) of an LED display screen; the display module (a) comprises a bottom case (b) and the lamp panel (c) of claim 8; the lamp panel (c) is installed on the bottom case (b).
